# FASCICULE DE BREVET EUROPEEN

(11) **EP 0 486 392 B1**
(45) Date de publication et mention de la délivrance du brevet: **09.11.1994**
(21) Numéro de dépôt: 91403056.4
(22) Date de dépôt: 14.11.1991
(51) Int. Cl.: H05K 3/40, H05K 1/14, H01L 23/485

(54) **Circuit hybride formé de deux circuits dont les pistes sont reliées par des billes de connexion électrique**
Aus zwei Schaltungen geformte Hybridschaltung, deren Leiterbahnzüge durch Verbindungskugeln elektrisch verbunden sind
Hybrid circuit formed by two circuits whose tracks are joined by electrical connection balls

(30) Priorité: 16.11.1990 FR 9014311
(43) Date de publication de la demande: 20.05.1992
(73) Titulaire: COMMISSARIAT A L'ENERGIE ATOMIQUE, 75015 Paris (FR)
(72) Inventeur: Petroz, Gérard, F-38330 Montbonnot (FR)
(74) Mandataire: Ilgart, Jean-Christophe

(56) Documents cités:
- EP-A- 0 355 965
- FR-A- 2 464 010
- PROCEEDINGS OF THE 37TH ELECTRONIC COMPONENTS CONFERENCE, IEEE NEW YORK, US, 11-13 MAI 1987, BOSTON, MA, pages 573-578; N. MATSUI ET AL.: 'VLSI Chip interconnection technology using stacked solder bumps'

## Description

L'invention se rapporte à un circuit hybride formé de deux circuits électroniques comportant chacun des pistes sur une face de connexion, les pistes des deux circuits électroniques étant reliées par des billes de connexion électrique.

La connexion par billes de matériaux à bas point de fusion est largement utilisée pour relier deux circuits électroniques et former ainsi un circuit composé ou hybride. Il existe des billes destinées à une connexion purement mécanique des circuits et d'autres billes qui relient des pistes conductrices des deux circuits et fournissent avant tout une connexion électrique. Cependant, en général, les billes assurent simultanément les deux fonctions de connexions électrique et mécanique comme cela est décrit dans la demande de brevet WO 87/01509.

Un certain nombre de circuits hybrides sont soumis à des amplitudes thermiques importantes au cours de leur fonctionnement. Quand les matériaux du substrat des deux circuits électroniques ont des coefficients de dilatation différents, les billes sont soumises à des contraintes de cisaillement qui finissent par les briser, directement ou par un phénomène de fatigue. Les contraintes sont normalement plus importantes à la périphérie des deux circuits électroniques car les déplacements dus aux dilatations sont plus marqués. Quand une bille est brisée, elle ne peut évidemment plus connecter les deux circuits électroniques, dont le fonctionnement est compromis s'il s'agit d'une bille de connexion électrique.

Une technique répandue pour prolonger la vie du circuit hybride consiste à agir sur la forme des billes de connexion. Quand la matière destinée à constituer une bille est fondue pour mouiller les circuits électroniques et former une soudure une fois qu'elle est solidifiée à nouveau, elle prend une forme qui dépend de son volume, de l'écartement des circuits électroniques et des surfaces mouillables des deux circuits auxquelles elle adhère et sur lesquelles elle s'étale à l'état liquide. On peut ainsi corriger l'action des forces de tension superficielle, qui donneraient des billes sphériques, pour obtenir des billes en forme de colonnettes plus ou moins élancées, renflées ou au contraire rétrécies au centre, comme cela est décrit dans la demande de brevet JP-A-62 15 0837 (Patent abstracts of Japan, vol. 11 n° 384).

Les billes en forme de colonnettes élancées et peu renflées, c'est-à-dire éloignées de la forme sphérique, ne sont en effet sujettes qu'à des concentrations de contraintes modérées. On réduit ainsi les problèmes de fatigue mais sans les éliminer complètement.

Une autre solution décrite dans l'article de Norio Matsui publié dans IEEE Transactions on Components, hybrids, and Manufacturing Technology (vol. CHMT 12, n° 4, December 1987 p566-570) consiste à juxtaposer verticalement des billes pour obtenir des colonnes dans lesquelles les contraintes seraient réduites. Dans ce cas, le résultat obtenu équivalent au précédent, n'est pas satisfaisant et nécessite un appareillage très lourd et des opérations nombreuses et délicates.

Dans l'invention, on recourt au contraire à des billes de connexion électrique aussi arrondies que possible, voire quasi sphériques. Ces billes relient des pistes des circuits électroniques qui présentent des parties, à l'emplacement et autour des zones de connexion, qui n'adhèrent pas aux circuits électroniques.

De telles zones non adhérentes sur un substrat sont utilisées dans le brevet européen 0 335 965 pour soulager les contraintes produites par les dilatations différentielles sur les éléments de connexion, mais qui sont là cylindriques ou aplatis et rigidement reliés au composant qu'elles unissent au substrat On ne retrouve donc pas la possibilité de rouler offerte par la combinaison de la bille et de deux zones non adhérentes, qui allège beaucoup mieux les contraintes, notamment quand les pistes sont soumises à du cisaillement, produit par des dilatations différentielles qui leur sont perpendiculaires.

Ces parties libres ont de préférence une longueur au moins égale au rayon des billes. Le circuit hybride peut comprendre des billes supplémentaires correspondant à celles de l'art antérieur et assurant simultanément la tenue mécanique et la connexion électrique entre les circuits électriques qui sont regroupées dans une région centrale du circuit hybride ; en effet, dans la région centrale du circuit hybride, les dilatations différentielles entre les deux circuits électroniques formant le circuit hybride sont faibles et négligeables. Les billes de connexion électrique conformes à l'invention se trouvent dans une région périphérique, les parties des pistes qui n'adhèrent pas aux circuits étant de préférence perpendiculaires aux directions respectives qui mènent à la région centrale.

On va maintenant décrire l'invention plus en détail à l'aide des figures suivantes annexées à titre illustratif et non limitatif :
- les figures 1, 2 et 3 représentent une bille selon l'invention et les parties adjacentes des circuits électroniques suivant des vues de dessus, de côté et de face ;
- la figure 4 illustre le fonctionnement de l'invention ; et
- les figures 5 et 6 représentent deux genres de circuits hybrides.

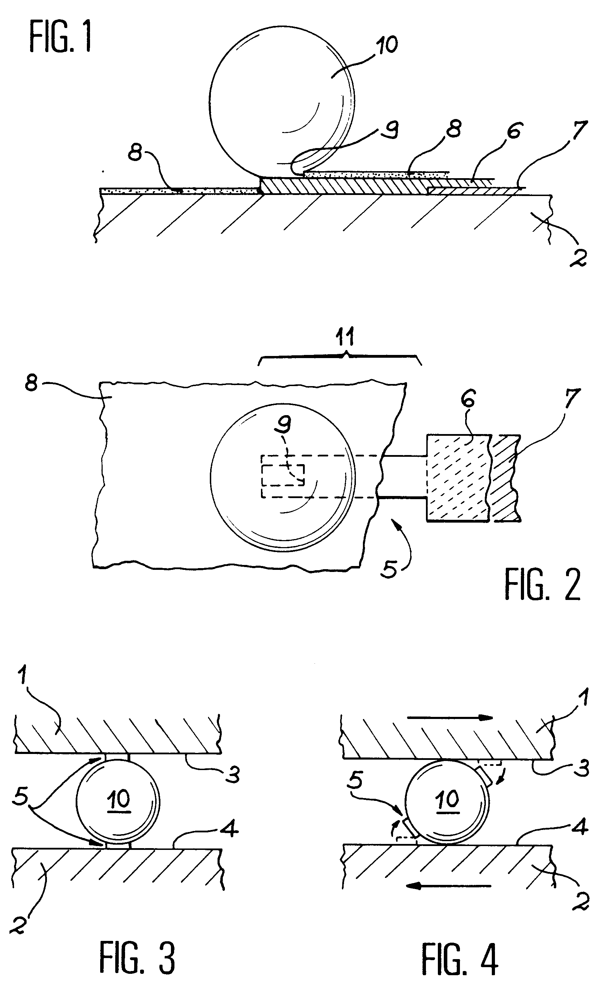

On se reporte tout d'abord aux figures 1 à 3. Les circuits électroniques 1 et 2 comportent pour l'essentiel un substrat qui peut être en silicium pour l'un, en alumine ou en composés II-VI ou III-V pour l'autre, et qui possède une face de connexion, respectivement 3 et 4. Les faces de connexion 3 et 4 sont parallèles et portent des pistes 5 pour la transmission de signaux électriques. Chaque piste 5 est formée essentiellement par une bande 6 de matériau conducteur de l'électricité, tel que l'or, déposé en une couche mince sur la face de connexion 3 ou 4. Toutefois, comme l'or n'adhère pas aux substrats usuels, une sous-couche 7 est déposée sur la face de connexion 3 ou 4 avant de déposer la couche dont la gravure donne ensuite les bandes conductrices 6. Elle est en un matériau, tel que le chrome ou le titane, qui adhère à la fois aux matériaux du substrat et des bandes conductrices 6, qui sont ainsi collées à la face de connexion 3 ou 4.

Généralement, une couche de passivation 8 est déposée sur les bandes conductrices 6 pour les protéger. Elle peut être en dioxyde de silicium ou en sulfure de zinc et présente des ouvertures sur des parties des couches conductrices 6 qui forment des zones de connexion 9. Des billes 10 de connexion électrique s'étendent entre des zones de connexion 9 de deux pistes 5 disposées respectivement sur les faces de connexion 3 et 4. Les billes 10 sont en un métal ou un alliage à bas point de fusion tel que l'indium, l'indium-étain ou l'étain-plomb.

Les bandes conductrices 6, la sous-couche 7 et la couche de passivation 8 sont formées sur les faces de connexion 3 ou 4 par les techniques, usuelles dans ce domaine, de dépôt de couches uniformes et de gravure de ces couches par des masques appropriés, ce qui ne nécessite pas de commentaires particuliers. La matière devant constituer les billes 10 est ensuite déposée sur les zones de connexion 9.

Le circuit électronique 2 est alors chauffé dans un milieu désoxydant jusqu'à ce que la matière devant constituer les billes 10 fonde et se redresse sous l'effet des forces de tension superficielles. Cette matière est choisie de manière à mouiller la matière des bandes conductrices 6 mais pas celle de la couche de passivation 8. Les billes 10, obtenues après refroidissement et solidification, ont finalement une forme sphérique tronquée aux zones de connexion 9, où la matière des billes 10 s'étale sur les portions dénudées des bandes conductrices 6.

Le second circuit électronique 1 est ensuite posé sur les billes 10 qui sont soumises à une nouvelle fusion sans laisser les circuits 1 et 2 se rapprocher. Les machines actuelles d'hybridation permettent de régler l'écartement des faces de connexion 3 et 4 avec une grande précision. La matière des billes 10 s'étale sur les zones de connexion 9 de l'autre face de connexion 3, pratiquement sans changement de la forme des billes 10, et la connexion entre les circuits électroniques 1 et 2 est établie dès que les billes 10 sont de nouveau solidifiées.

Les zones de connexion 9 sont avantageusement petites pour obtenir des billes aussi sphériques que possible : la largeur des pistes 5 est de préférence petite par rapport au diamètre des billes 10 (4 et 20 microns respectivement par exemple).

Selon l'invention, la sous-couche d'adhérence 7 n'existe pas sous des parties libres 11 des pistes 5 qui s'étendent au-dessous des billes 10, et comprennent en particulier les zones de connexion 9 ainsi que des zones situées de part et d'autre de la zone de connexion 9. Les parties libres 11 n'adhèrent donc pas aux faces de connexion 3 et 4.

Quand le circuit hybride formé des deux circuits électroniques 1 et 2 est soumis à un échauffement ou un refroidissement important, les différences de dilatations qui peuvent se produire se traduisent par un mouvement de glissement mutuel des deux circuits électroniques 1 et 2 parallèlement à leurs plans. La figure 4 représente le résultat obtenu : les billes 10 roulent sur les deux faces de connexion 3 et 4 sans pratiquement subir des efforts et les parties libres 11 sont décollées et soumises à des déformations de torsion. Cependant, les contraintes qui en résultent sont faibles en pratique par rapport aux contraintes que la bille 10 devrait supporter si elle était rigidement reliée aux circuits 1 et 2 car les couches conductrices 6 ont une faible épaisseur et le roulement des billes 10 est un mouvement qui déplace relativement peu les parties libres 11, du moins pour des angles de rotation modérés. On cherche donc à placer les parties libres 11 perpendiculairement aux dilatations thermiques différentielles dans le circuit hybride.

Il est avantageux que les parties libres 11 soient plus étroites que le reste des pistes 5, ce qui a été représenté à la figure 2, pour limiter les contraintes de torsion. La partie de la couche de passivation 8 qui se trouve au-dessus des parties libres 11 est déchirée au premier mouvement des billes 10 et suit les bandes conductrices 6.

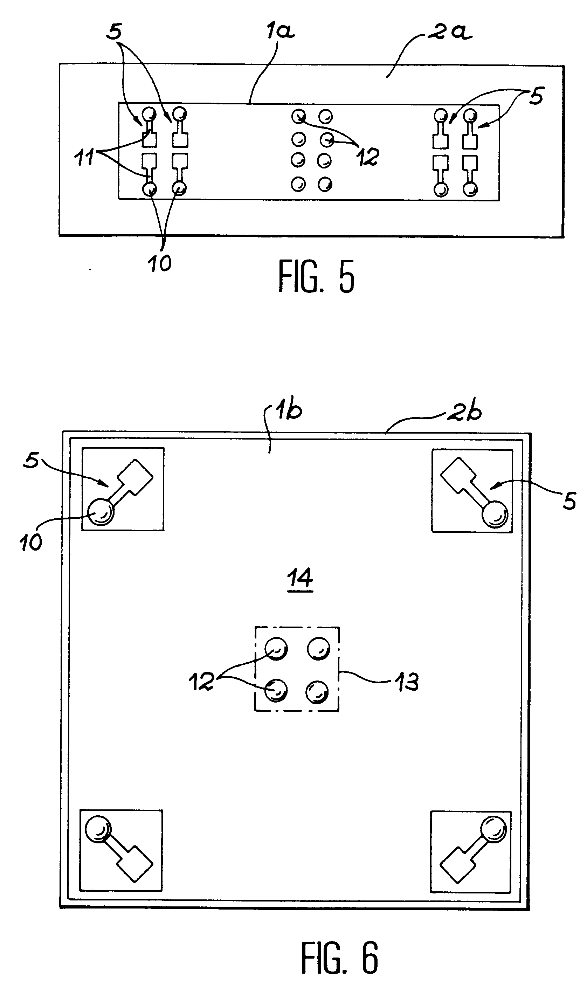

La souplesse de la liaison est la plus grande pour des mouvements des billes 10 perpendiculaires aux parties libres. Deux genres de circuits hybrides conçus en fonction de cette remarque sont représentés aux figures 5 et 6. Dans la figure 5, les circuits 1a et 2a sont des barrettes allongées. Les pistes 5 et les parties libres 11 s'étendent suivant la dimension transversale des barrettes 1a et 1b. Les billes 10 de connexion électrique sont réparties suivant une rangée longitudinale. La connexion mécanique entre les circuits 1a et 1b est assurée par quelques rangées transversales de billes de connexion mécanique 12 conformes à l'art antérieur au centre des barrettes 1a et 1b. Si des dilatations thermiques se produisent, elles sont essentiellement longitudinales.

Les circuits électroniques 1b et 2b de la figure 6 ont une forme carrée et sont reliés entre eux par des billes 12 concentrées dans une région centrale 13. Les contraintes appliquées à ces billes sont négligeables, aussi ces dernières seront conformes à l'art antérieur. Le reste des circuits 1b et 2b forme une région périphérique 14 qui entoure la précédente et sur laquelle les pistes 5 porteuses des parties 11 et des billes 10 de connexion électrique sont orientées de manière à être perpendiculaires aux directions menant des billes 10 respectives à la région centrale 13. En effet, si des dilatations thermiques différentielles se produisent, elles seront principalement radiales et croissantes à partir de la région centrale 13.

L'invention peut être mise en oeuvre d'autres manières, notamment avec des matériaux différents. Tous les matériaux utilisés normalement dans cette technique et qui présentent les propriétés évoquées plus haut pour la réalisation de l'invention peuvent convenir. Les billes 10 peuvent avoir un diamètre de quelques dizaines de micromètres, la sous-couche 7 et la couche de passivation 8 des épaisseurs de quelques centaines de nanomètres, les parties libres 11 des largeurs de quelques micromètres. Il faut remarquer que les billes 10 peuvent être constituées de matériaux qui sont exclus dans les conceptions où elles sont soumises à des contraintes de cisaillement, notamment de matériaux durs qui roulent facilement et sans s'aplatir sous le poids du circuit électronique 1 ou 2 supérieur mais que leur faible ductilité rend inaptes à subir des déformations notables. C'est ainsi que le pied des billes 10 est le siège d'une diffusion locale du métal des bandes conductrices 6. Dans le cas d'or et d'indium, l'alliage qui est formé est plus dur que l'indium et résiste donc moins bien aux déformations, ce qui est désavantageux dans les conceptions antérieures car il se trouve précisément à l'endroit où les contraintes de cisaillement sont les plus importantes. Dans l'invention, l'alliage accroît la dureté de l'endroit soumis au roulement et améliore donc celui-ci.

## Revendications

1. Circuit hybride formé de deux circuits électroniques (1, 2) comportant chacun des pistes (5) sur une face de connexion (3, 4), des billes (10) assurant les connexions entre les pistes (5) des faces (3, 4), caractérisé en ce que les pistes (5) comprennent, à l'emplacement et autour des zones de connexion (9), des parties libres (11) qui n'adhèrent pas aux circuits électroniques (1, 2), et en ce que les billes (10) relient électriquement et mécaniquement les parties libres (11) des pistes (5) sur les faces (3,4) de connexion.

2. Circuit hybride selon la revendication 1, caractérisé en ce que les parties libres (11) des pistes (5) des faces de connexion (3, 4) sont perpendiculaires à la direction des dilatations thermiques différentielles sur le circuit hybride.

3. Circuit hybride selon la revendication 1 ou 2, caractérisé en ce que les parties libres (11) des pistes ont une longueur au moins égale au rayon des billes.

4. Circuit hybride selon l'une quelconque des revendications 1 à 3, caractérisé en ce que les parties libres (11) des pistes (5) constituent des rétrécissements des pistes (5).

5. Circuit hybride selon l'une quelconque des revendications 1 à 4, caractérisé en ce qu'il comprend des billes de connexion mécanique (12) entre les circuits électroniques (1, 2) dans une région centrale (13), et des billes de connexion électrique dans une région périphérique (14), les parties libres (11) des pistes étant perpendiculaires aux directions respectives qui mènent à la région centrale.

## Patentansprüche

1. Hybridschaltung, gebildet aus zwei elektronischen Schaltungen (1, 2), jede Leiterbahnen (5) umfassend auf einer Verbindungsfläche (3, 4) und Kugeln (10), die die Verbindungen zwischen den Leiterbahnen (5) der Flächen (3, 4) sicherstellen,
**dadurch** **gekennzeichnet**,
daß die Leiterbahnen (5) am Anbringungsort und um Verbindungszonen (9) herum freie Teile (11) umfassen, die nicht an den elektronischen Schaltungen (1, 2) haften, und dadurch, daß die Kugeln (10) die freien Teile (11) der Leiterbahnen (5) elektrisch und mechanisch mit den Verbindungsflächen (3, 4) verbinden.

2. Hybridschaltung nach Anspruch 1, dadurch gekennzeichnet, daß die freien Teile (11) der Leiterbahnen (5) der Verbindungsflächen (3, 4) senkrecht sind zur Richtung der differentiellen Wärmeausdehnungen an der Hybridschaltung.

3. Hybridschaltung nach Anspruch 1 oder 2, dadurch gekennzeichnet, daß die freien Teile (11) der Leiterbahnen eine Länge wenigstens gleich dem Radius der Kugeln haben.

4. Hybridschaltung nach einem der Ansprüche 1 bis 3, dadurch gekennzeichnet, daß die freien Teile (11) der Leiterbahnen (5) Verengungen der Leiterbahnen (5) bilden.

5. Hybridschaltung nach einem der Ansprüche 1 bis 4, dadurch gekennzeichnet, daß sie Kugeln (12) zur mechanischen Verbindung zwischen den elektronischen Schaltungen (1, 2) in einem zentralen Bereich (13) umfaßt, und Kugeln zur elektrischen Verbindung in einem peripheren Bereich (14), wobei die freien Teile (11) der Leiterbahnen senkrecht sind zu den jeweiligen Richtungen, die zum zentralen Bereich führen.

## Claims

1. Hybrid circuit formed on two electronic circuits (1, 2), each comprising tracks (5) on one connection face (3, 4), balls (10) ensuring the connections between the tracks (5) of the faces (3, 4), characterized in that the tracks (5) include at the location of and around the connection zones (9) free portions (11) not adhering to the electronic circuits (1, 2) and in that the balls (10) electrically and mechanically connect the free portions (11) of the tracks (5) on the connection faces (3, 4).

2. Hybrid circuit according to claim 1, characterized in that the free portions (11) of the tracks (5) of the connection faces (3, 4) are perpendicular to the direction of the differential thermic expansions on the hybrid circuit.

3. Hybrid circuit according to claim 1 or 2, characterized in that the free portions (11) of the tracks (5) have a length equal at least to the radius of the balls.

4. Hybrid circuit according to any one of the claims 1 to 3, characterized in that the free portions (11) of the tracks (5) constitute contractions of the tracks (5).

5. Hybrid circuit according to any one of the claims 1 to 4, characterized in that it includes mechanical connection balls (12) between the electronic circuits (1, 2) in a central region (13) and electrical connection balls in a peripheral region (14), the free portions (11) of the tracks being perpendicular to the respective directions leading to the central region.
